# EUROPÄISCHE PATENTSCHRIFT

(11) **EP 0 349 805 B1**
(45) Veröffentlichungstag und Bekanntmachung des Hinweises auf die Patenterteilung: **14.09.1994**
(21) Anmeldenummer: 89110929.0
(22) Anmeldetag: 16.06.1989
(51) Int. Cl.: H05K 3/42, C23C 18/22

(54) **Verfahren zur Ätzung von Epoxid-Harz**
Process for etching epoxy resin
Procédé de décapage de résine époxy

(30) Priorität: 05.07.1988 DE 3823137
(43) Veröffentlichungstag der Anmeldung: 10.01.1990
(73) Patentinhaber: ATOTECH Deutschland GmbH, 10553 Berlin (DE)
(72) Erfinder: Grapentin, Hans-Joachim, D-1000 Berlin 19 (DE); Kayser, Tomas, D-1000 Berlin 65 (DE); Riedl, Andrea, D-1000 Berlin 61 (DE)
(74) Vertreter: Effert, Udo, Dipl.-Ing.

(56) Entgegenhaltungen:
- WO-A-86/00085
- GB-A- 1 135 219
- US-A- 4 132 585

## Beschreibung

Die Erfindung betrifft ein Verfahren zur Ätzung von Epoxid-Harz mit einer Rückätzrate von größer als 3 µm, insbesondere in Bohrlöchern mit Leiterplatten, unter Verwendung stabiler, stark basischer Alkali-Permanganat-Ätzlösungen.

Bei der Herstellung von Mehrlagenschaltungen ist es notwendig, zur Entfernung von durch den Bohrprozeß hervorgerufenen Harzverschmierungen, ein entsprechendes Vorbehandlungsverfahren durchzuführen. Die Entfernung dieser Verschmutzungen soll der sicheren Ankontaktierung der leitenden "Multilayer-Kupferinnenlagen" mit der chemisch aufgebrachten Kupferschicht dienen. Die durch die Epoxid-Harz-Entfernung durchgeführte Reinigung des Bohrloches, bei gleichzeitiger Aufrauhung der Substratoberfläche, dient außerdem der besseren Haftung der bei einer stromlos oder direkt elektrolytisch abgeschiedenen Metallschicht - wichtig vor allem nach der thermischen Belastung, der die Leiterplatte im späteren Lötprozeß ausgesetzt ist.

Es ist bekannt, den oben beschriebenen Prozeß mit alkalischen Kalium- oder Natriumpermanganatlösungen durchzuführen, wobei in der Regel vor der oxidativen Behandlung eine Konditionierung mittels organischer Lösungsmittel und/oder Tensiden erfolgt, was jedoch sehr lange Behandlungszeiten erfordert. Da in den meisten Fällen außerdem nur geringe Rückätzraten erreicht werden, wurde bereits vorgeschlagen, diese Raten z. B. durch
- Einsatz von Ultraschall
- Erhöhung der Temperaturen
- Erhöhung der Konzentration an Permanganat durch Einsatz von Natriumpermanganat
- Erhöhung der Konzentration an (OH⁻)-Ionen,

zu steigern, was jedoch entweder eine Schädigung des Basismaterials oder eine starke Entstabilisierung des Permanganatsystems zur Folge hat.

Aus WO-A-86 00 085 ist bekannt, die Standzeit von alkalischen Permanganat-Ätzlösungen durch Zusatz von Oxidations mitteln zu erhöhen, die Manganat zu Permanganat zu oxidieren vermögen.

Der Erfindung liegt daher die Aufgabe zugrunde, ein Verfahren der eingangs genannten Art zu schaffen, welches eine schonende Ätzung von Epoxid-Harz mit hoher Rückätzrate bei gleichzeitiger Stabilisierung des Permanganatsystems und bei gleichbleibender Konzentration ermöglicht.

Diese Aufgabe wird erfindungsgemäß durch ein Verfahren mit den Merkmalen des Patentanspruches 1 gelöst.

Weitere Ausgestaltungen der Erfindung sind den kennzeichnenden Teilen der Unteransprüche zu entnehmen.

Das erfindungsgemäße Verfahren ermöglicht in bisher nicht erreichter Weise eine Stabilisierung von zum starken Rückätzen und Aufrauhen von Epoxid-Harzen verwendeten hoch alkalischen Permanganat-Ätzlösungen.

Der besondere Vorteil des erfindungsgemäßen Verfahren besteht darin, daß eine praktisch unbegrenzte Lebensdauer dieser Ätzlösungen mit hoher Alkalität und damit hoher Ätzrate erzielt wird. Dadurch ist es erstmals möglich, eine praktikable Rückätzung von Epoxid-Harzen mit einer Permanganatlösung durchzuführen.

Ein weiterer Vorteil des erfindungsgemäßen Verfahrens bietet außerdem die so genannte "3-Punkt-Kupferinbindung" an den Innenlagen von Mehrlagenschaltungen.

Die Stabilisierung der Permanganat-Ätzlösungen erfolgt durch anodische elektrochemische Oxidation.

Zweckmäßigerweise verwendet man hierfür eine Vorrichtung, die zwei durch ein Diaphragma von einander getrennte Elektrolyträume enthält, von denen der eine den Anolytraum und der andere den Katholytraum darstellt.

Die Oxidation wird bei einer Gleichspannung von 0,5 - 25 Volt und einer Stromdichte von 0.1 - 20 A/dm² durchgeführt.

Diese Stabilisierung wird mit einer Regelung der Permanganat- und der OH⁻-Ionenkonzentration gekoppelt.

Diese Regelung wird durch elektrochemische und/oder photometrische Messungen durchgeführt.

Vorteilhafterweise wird zur Regelung und Messung der Permanganat-Konzentration eine Vorrichtung eingesetzt, wie sie in der deutschen Patentanmeldung P 37 16 013.-3 vorgeschlagen wurde.

Und zwar wird eine Tauchsonde mit Photoelement verwendet, welche jede Konzentrationsveränderung einem Massenverstärker als fallender oder steigender Strom zuführt, womit in an sich bekannter Weise eine Dosiervorrichtung bis zur Erreichung des Sollwerts betätigt wird.

Die Messung und Regelung der OH⁻-Ionenkonzentration erfolgt andererseits durch eine Redox-Messung mit einer entsprechenden Vorrichtung, wobei das gemeldete Signal auf einen Massenverstärker gegeben wird, dessen Ausgang einen fallenden oder steigenden Stom produziert, der ebenfalls in an sich bekannter Weise eine Dosiervorrichtung bis zur Erreichung des Sollwerts betätigt.

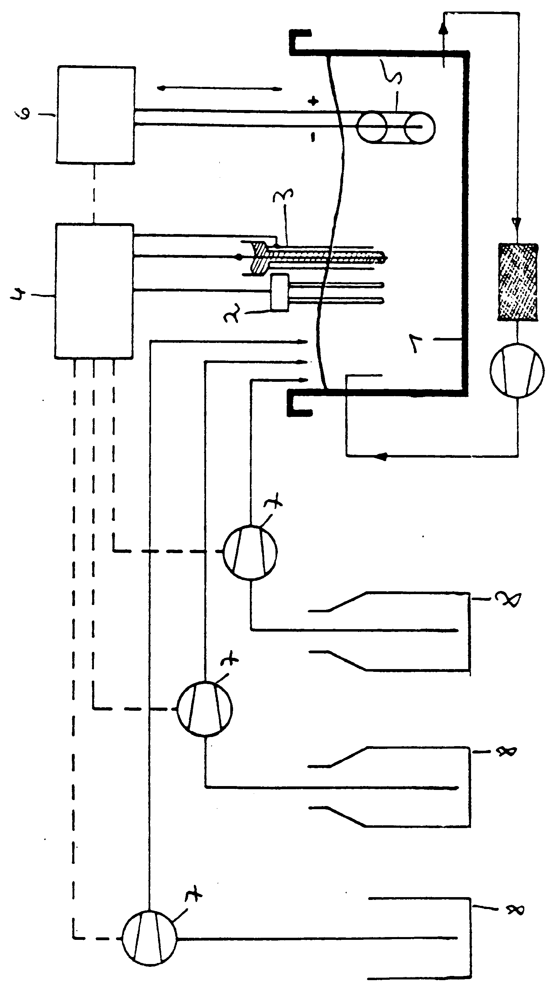

Eine Vorrichtung zur Durchführung des erfindungsgemäßen Verfahrens zeigt die Figur.

Hierin bedeuten:
1. Arbeitstank
2. Tauchsonde mit Photoelement
3. Redox-Meßvorrichtung
4. Regelgerät
5. Vorrichtung zur anodischen Oxidation
6. Transformator
7. Dosierpumpen
8. Vorratsbehälter

Das folgende Beispiel dient zur Erläuterung der Erfindung.

### Beispiel

Es wurde normales Epoxid-Harz (FR4) mit einem TG-Punkt von etwa 135°C verwendet. Da die Ätzratenbestimmung über die sonst üblicherweise publizierte "Gewichtsverlustmethode" pro Fläche abweichende Ergebnisse von der Praxis ergab, wurde diese über Querschliffe ermittelt, wobei die Differenzen von Epoxid-Harz zu Glas oder der Kupferinnenlage als praktische Rückätzrate zu Grunde gelegt wurden.

Eine Kaliumpermanganat-Ätzlösung wurde wie folgt neu angesetzt:
- 60: g/Liter KMnO₄
- 70: g/Liter NaOH
- 0,1: g/Liter fluoriertes Netzmittel

Die Dichte der Lösung betrug bei 70°C gemessen 1,07 g/cm³; die Epoxid-Harz-Ätzrate erfolgt nach 15 minütiger Behandlungszeit. Nach einem praktischen Durchsatz von 4m²/l Zuschnitt (Leiterplatten) mußte die Lösung wegen der Bildung eines starken Bodensatzes mit einer Dichte von 1,38 g/cm³ bei 70°C und geringer Ätzrate bei Epoxid-Harz (< 2 µm ) verworfen werden).

Der Versuch wurde unter Stabilisierung der Ätzlösung durch anodische Oxidation mit einer anodischen Stromdichte von 6 A/dm² und Regelung der Konzentration an
- Kaliumpermanganat: zwischen 55 und 60 g/Liter und
- Kaliummanganat: zwischen 15 und 17 g/Liter

durch photometrische Messung und entsprechende Zudosierung wiederholt.

Nach dem Neuansatz wurden folgende Werte gemessen:
- Dichte bei 70°C: : 1,068 g/cm³
- Epoxid-Harz-Ätzrate: : 17 µm

Nach 20 m²/l Durchsatz an Leiterplatten:
- Dichte bei 70°C: : 1,08 g/cm³
- Epoxid-Harz-Ätzrate: : 16 µm

## Patentansprüche

1. Verfahren zur Ätzung von Epoxid-Harz mit einer Rückätzrate von größer 3 µm, insbesondere in Bohrlöchern von Leiterplatten mit einer Alkali- Permanganat -Ätzlösung, enthaltend 10 bis 100 g/Liter Alkali-Permanganat und mindestens 30 g/Liter Alkalihydroxid, mit den Verfahrenschritten :
a) Stabilisierung der Permanganat-Ätzlösung durch elektrochemische anodische Oxidation bei einer Gleichspannung von 0,5 bis 25 Volt und einer Stromdichte von 0,1 bis 20 Ampere /dm² ,
b.) Regelung der Permanganat- und OH⁻-Ionenkonzentration durch elektrochemische und/oder photometrische Messung und entsprechende Zudosierung bei Abweichung vom Sollwert.

2. Verfahren gemäß Anspruch 1, dadurch gekennzeichnet, daß die photometrische Messung der Permanganat- Ionenkonzentration über eine Tauchsonde mit Photoelement erfolgt, wobei bei jeder Konzentrationsveränderung einem Massenverstärker ein fallender oder steigender Strom zugeführt wird, wodurch eine Dosiervorrichtung betätigt wird.

3. Verfahren gemäß Anspruch 1, dadurch gekennzeichnet, daß die OH⁻-Ionenkonzentration durch eine elektrochemische Redox-Messung erfolgt, wobei das gemessene Signal einem Massenverstärker zugeführt wird, dessen Ausgang einen fallenden oder steigenden Strom produziert, der eine Dosiervorrichtung betätigt.

## Claims

1. Method of etching epoxy resin at a re-etching rate greater than 3 µm, more especially in bores of printed circuit boards, utilising an alkali permanganate etching solution containing 10 to 100 g/litre alkali permanganate and at least 30 g/litre alkali hydroxide, by the following method steps:
a) stabilising the permanganate etching solution by electrochemical, anodic oxidation at a direct voltage from 0.5 to 25 volts and a current density from 0.1 to 20 amperes/dm²,
b) regulating the permanganate and OH⁻ ion concentration by electrochemical and/or photometric measurement and appropriate additional dosage in the event of a deviation from the desired value.

2. Method according to claim 1, characterised in that the photometric measurement of the permanganate ion concentration is effected by an immersion probe provided with a photocell, a falling or rising current being supplied to a mass amplifier in the event of any change in concentration, a dosing device being actuated by said current.

3. Method according to claim 1, characterised in that the OH⁻ ion concentration is effected by an electrochemical Redox measurement, the measured signal being supplied to a mass amplifier, the output of which produces a falling or rising current which actuates a dosing device.

## Revendications

1. Procédé pour graver chimiquement de la résine époxy, selon une gravure en retrait supérieure à 3µm, en particulier dans des trous de cartes imprimées, avec une solution de gravure chimique au alcali permanganate, contenant de 10 à 100 g/litre d'alcali permanganate et au moins 30g/litre d'alcali hydroxide, comprenant les étapes consistant à:
a) Stabiliser la solution de gravure chimique au permanganate par une oxydation électrochimique anodique sous une tension continue de 0,5 à 25 Volts et pour une densité de courant de 0,1 à 20 Ampères/dm².
b) Régler la concentration en ions de permanganate et d'OH⁻ par mesure électrochimique et/ou photométrique et par dosage complémentaire correspondant en cas d'écart par rapport à la valeur de consigne.

2. Procédé selon la revendication 1, caractérisé en ce que la mesure photométrique de la concentration en ions de permanganate s'opère grâce à une sonde immergée comportant un photo-élément, un courant croissant ou décroissant étant transmis à un amplificateur de masse, lors de toute variation de la concentration, ce qui actionne un dispositif de dosage.

3. Procédé selon la revendication 1, caractérisé en ce que la concentration en ions d'OH⁻ s'opère par une mesure redox électrochimique, le signal mesuré étant acheminé vers un amplificateur de masse, dont la sortie produit un courant croissant ou décroissant, qui actionne un dispositif de dosage.
